# EUROPEAN PATENT APPLICATION

(11) **EP 4 645 668 A1**
(43) Date of publication of application: **05.11.2025**
(21) Application number: 23925946.8
(22) Date of filing: 21.08.2023
(51) Int. Cl.: H02M 7/00, H05K 7/14

(54) **STRING INVERTER**

(30) Priority: 03.03.2023 CN 202310217402
(71) Applicant: Sungrow Power Supply Co., Ltd., Hefei, Anhui 230088 (CN)
(72) Inventor: ZHANG, Qing, Hefei, Anhui 230088 (CN); CHEN, Peng, Hefei, Anhui 230088 (CN); TAO, Gaozhou, Hefei, Anhui 230088 (CN); SHEN, Zhanliang, Hefei, Anhui 230088 (CN)
(74) Representative: Rooney, John-Paul
(86) International application number: PCT/CN2023/113967
(87) International publication number: WO 2024/183242

(57) **Abstract**

A string inverter, comprising an inverter main body and multiple wiring modules. The wiring modules are detachably assembled to the inverter main body, the wiring modules each have an input end, and at least some of the wiring modules have different types of input ends. In the solution, the wiring modules are independent of each other, so that during product assembly, the wiring modules having particular types of input ends can be matched according to requirements, and then the type of the string inverter can be adjusted so as to adapt to different photovoltaic arrays for use, thereby improving the compatibility of the string inverter.

## Description

This application claims the priority to Chinese Patent Application No. 2023102174026, titled "STRING INVERTER", filed on March 3, 2023 with the China National Intellectual Property Administration, which is incorporated herein by reference in its entirety.

### FIELD

The present application relates to the technical field of inverters, and in particular to a string inverter.

### BACKGROUND

String inverters are commonly used in photovoltaic power generation systems to convert direct current (DC) generated by photovoltaic modules into alternating current (AC) and then aggregate and output the alternating current. Generally, different photovoltaic arrays require different types of string inverters, and various types of string inverters are incompatible with each other, resulting in a large number of types of string inverters and high product costs.

Therefore, how to provide a solution to overcome or alleviate the above defects is still a technical issue to be solved urgently by those skilled in the art.

### SUMMARY

An object of the present application is to provide a string inverter which has good compatibility and is capable of being adapted to various types of photovoltaic arrays.

To address the technical problem, a string inverter is provided according to the present application, which includes an inverter main unit and multiple wiring modules. Each of the wiring modules is detachably assembled to the inverter main unit and has an input end.

With the above solution, the wiring module is detachably mounted to the inverter main unit. As such, the wiring module has two states relative to the inverter main unit: a separated state and an assembled state. In the separated state, the wiring module may be connected to a DC input cable first. In this case, since the wiring module has not yet been connected to the inverter main unit, the installation of the DC input cable is not affected by the installation environment of the inverter main unit, and the connection between the DC input cable and the wiring module can be easily realized. Moreover, the weight of the individual wiring module is relatively small, which facilitates an operator to adjust its installation position or the like, and effectively reduces the labor intensity of the operator. Similarly, for the inverter main unit, the weight of the individual inverter main unit is also relatively small, facilitating the operator to install it on a wall, a bracket, and other components, thereby reducing labor intensity. In the assembled state, the wiring module can be connected to the inverter main unit to achieve electrical connection between the wiring module and the inverter main unit.

Since the wiring modules are independent of each other, the wiring modules with the appropriate types of the input ends can be selected as needed during product assembly. Thus, the type of the string inverter can be adjusted to adapt to different photovoltaic arrays for use, thereby improving the compatibility of the string inverter and effectively reducing the usage costs of the string inverter.

In an embodiment, the wiring module is a DC wiring module.

In an embodiment, the input end includes an input port. The number of the input ports of at least one of the wiring modules is different from that of the other of the wiring modules, and/or, an input current of the input port of at least one of the wiring modules is different from that of the other of the wiring modules.

In an embodiment, a DC circuit unit is arranged in the DC wiring module, and the DC circuit unit includes a DC switch, a DC lightning protection circuit, and a maximum power point tracking circuit.

In an embodiment, one of the wiring modules is an AC wiring module.

In an embodiment, the wiring module is located at an upper part and/or a lower part and/or a side part of the inverter main unit.

In an embodiment, the inverter main unit is provided with a slide rail, and the wiring module is slidably connected to the slide rail.

In an embodiment, the inverter main unit is provided with multiple partitions, and two adjacent wiring modules are separated by the partition; and a supporting plate is provided at a lower end of each of the partitions, and the supporting plate forms the slide rail.

In an embodiment, the string inverter further includes a hinge, and the wiring module is rotatably connected to the inverter main unit through the hinge.

In an embodiment, the wiring module is further provided with a limiting component for limiting an assembly position of the wiring module on the inverter main unit.

### BRIEF DESCRIPTION OF THE DRAWINGS

FIG. 1 is a schematic structural view of a string inverter according to a specific embodiment of the present application;
FIG. 2 is an exploded view of FIG. 1;
FIG. 3 is a schematic structural view of an inverter main unit in FIG. 1;
FIG. 4 is a schematic structural view of a wiring module in FIG. 1;
FIG. 5 is a schematic structural view showing wiring modules being mounted to an inverter main unit;
FIG. 6 is a schematic structural view of a wiring module being located at an upper part of an inverter main unit;
FIG. 7 is a schematic structural view of a wiring module being located on a left side of an inverter main unit;
FIG. 8 is a schematic structural view of a wiring module being located on a right side of an inverter main unit;
FIG. 9 is a schematic structural view of a string inverter according to another specific embodiment of the present application;
FIG. 10 is a schematic structural view of a DC circuit unit according to a specific embodiment of the present application;
FIG. 11 is a schematic structural view showing that one of the wiring modules is an AC wiring module.

Reference numerals in the drawings are listed as follows:
1 inverter main unit, 11 host unit, 12 docking unit, 121 back plate, 121a docking terminal, 122 side plate, 122a opening, 123 partition, 124 supporting plate, 13 hinge, 14 leg;
2 wiring module, 21 input end, 211 input port, 22 output end, 23 limiting component, 24 DC circuit unit, 241 DC switch, 242 DC lightning protection circuit, 243 maximum power point tracking circuit;
3 DC input cable;
4 AC output cable.

### DETAILED DESCRIPTION OF THE EMBODIMENTS

In order to enable those skilled in the art to better understand the technical solutions of the present application, the present application is described in detail below in conjunction with the accompanying drawings and specific embodiments.

In the description of the embodiments of the present application, it should be noted that, unless clearly specified or defined, terms "install", "link", "connect" and "assemble" should be understood broadly. For example, "connect" may refer to a detachable connection or a non-detachable connection, and it may refer to a direct connection or an indirect connection through an intermediate media. Among these, "rotatable connection" means that parts are connected to each other and can rotate relative to each other after being connected. "Sliding connection" means that parts are connected to each other and can slide relative to each other after being connected.

In the description of the embodiments of the present application, the terms "include", "comprise", or any other variants thereof are intended for non-exclusive inclusion. Therefore, a process, a method, an article, or a device comprising a series of elements comprises not only these elements but also another element not explicitly listed, or may further comprise an element inherent to such process, method, article or device. In the absence of further restrictions, an element defined by the statement "comprising a ..." does not exclude the presence of other identical elements in the process, method, article or device including the element.

In the description of the embodiments of the present application, the term "multiple" refers to two or more. When the term "multiple" is used to describe the number of different components, it does not indicate the relationship between the quantities of these components.

In the embodiments of the present application, the term "and/or" is used to describe an association relationship between associated objects, indicating three relationships. For example, the expression "A and/or B" may indicate that A exists alone, both A and B exist, and B exists alone. In addition, the character "/" herein generally indicates that the associated objects before and after the character "/" are in an "or" relationship.

### First Embodiment

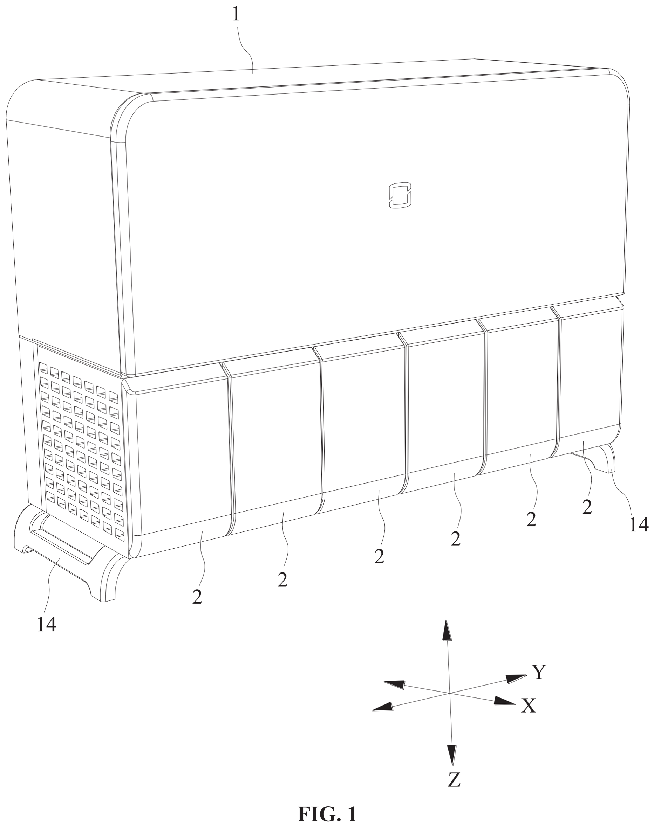

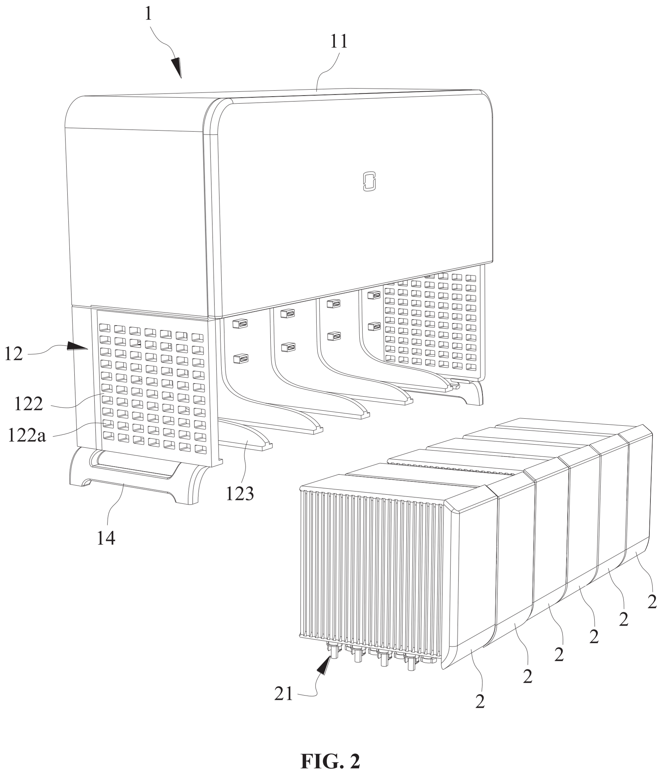

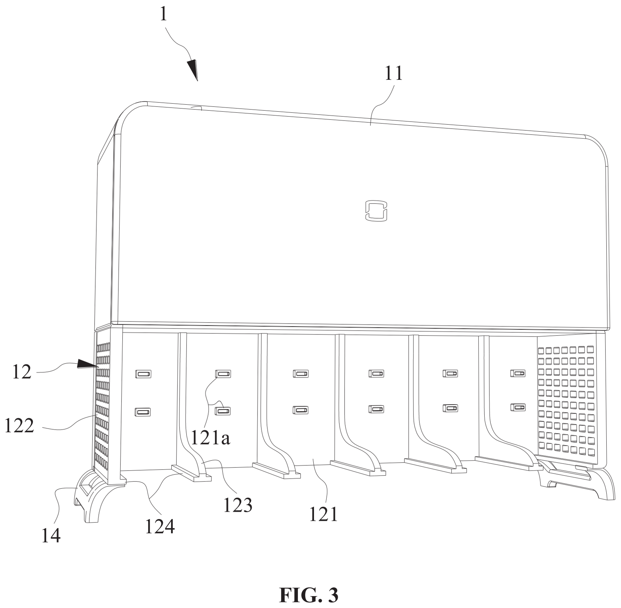

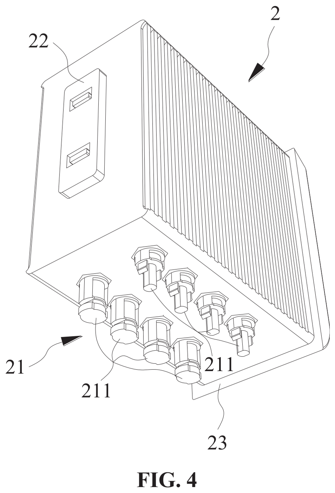

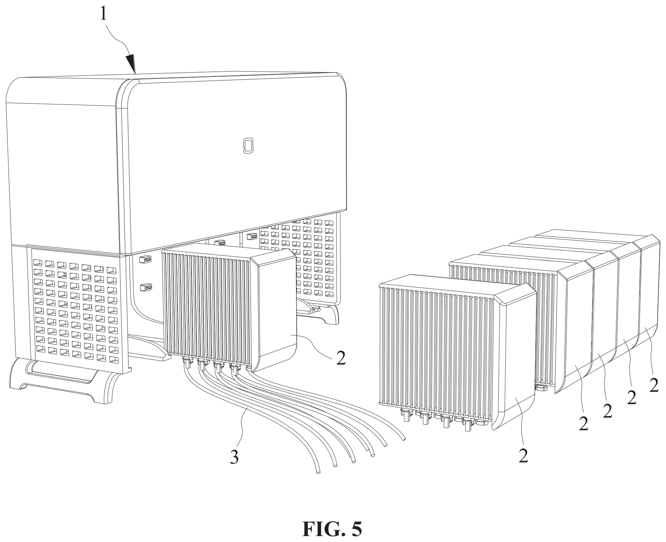

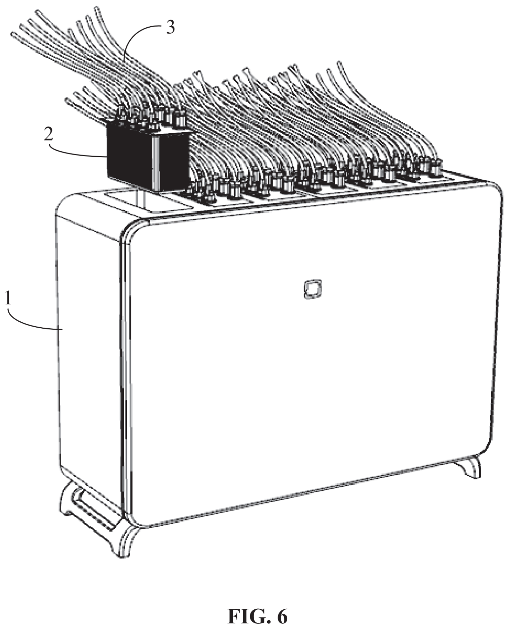

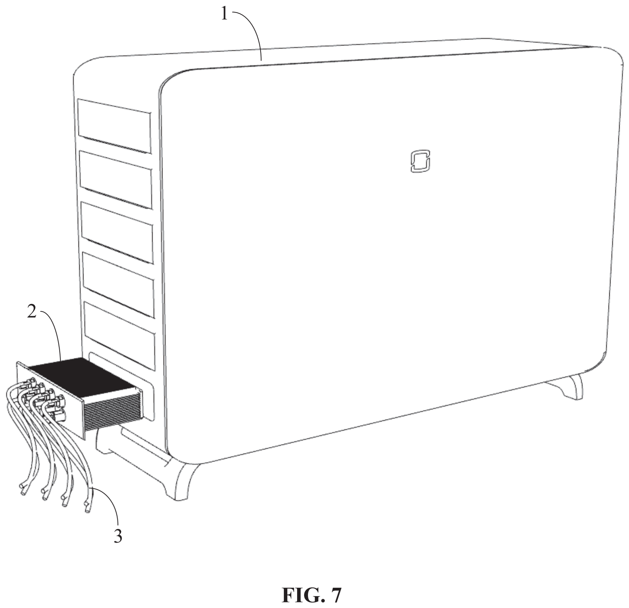

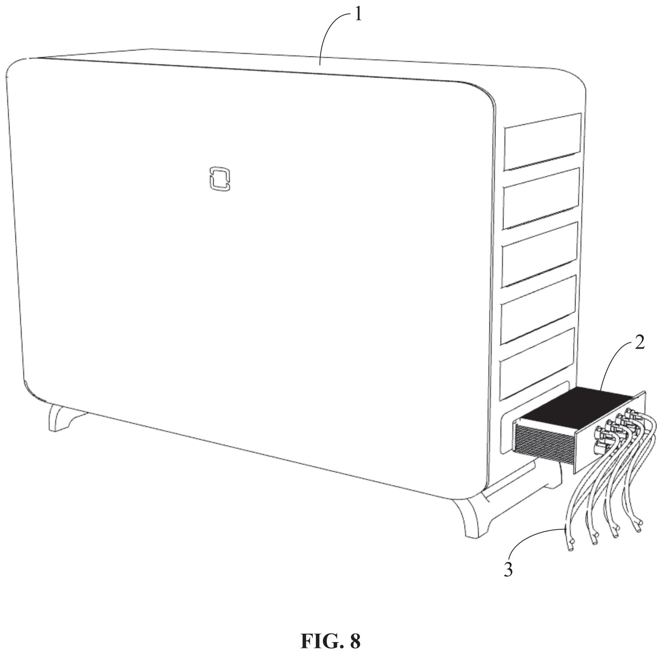

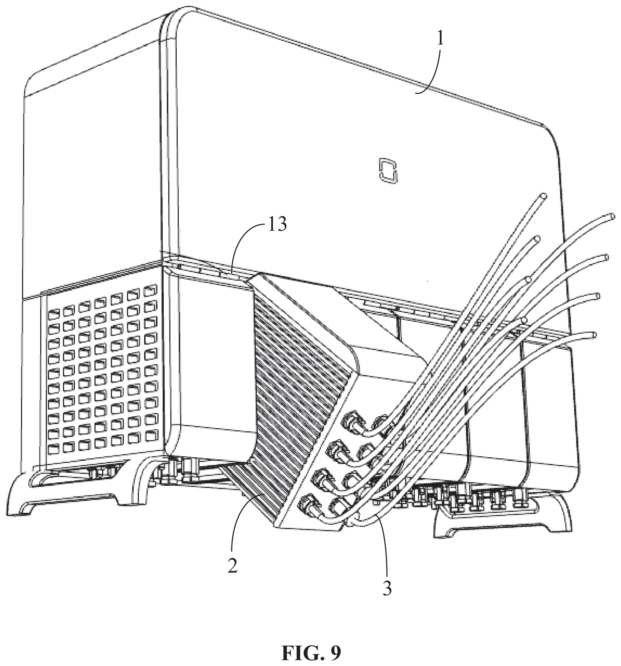

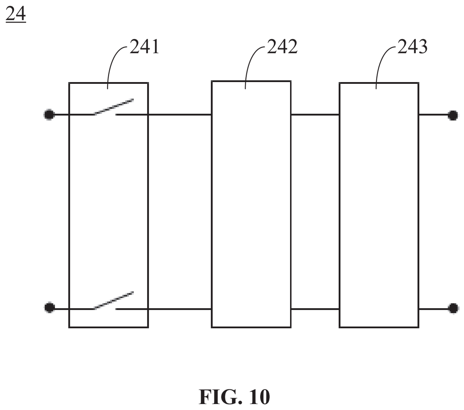

Reference is made to FIGS. 1 to 10. FIG. 1 is a schematic structural view of a string inverter according to a specific embodiment of the present application. FIG. 2 is an exploded view of FIG. 1. FIG. 3 is a schematic structural view of an inverter main unit in FIG. 1. FIG. 4 is a schematic structural view of a wiring module in FIG. 1. FIG. 5 is a schematic structural view showing wiring modules being mounted to an inverter main unit. FIG. 6 is a schematic structural view of a wiring module being located at an upper part of an inverter main unit. FIG. 7 is a schematic structural view of a wiring module being located on a left side of an inverter main unit. FIG. 8 is a schematic structural view of a wiring module being located on a right side of an inverter main unit. FIG. 9 is a schematic structural view of a string inverter according to another specific embodiment of the present application. FIG. 10 is a schematic structural view of a DC circuit unit according to a specific embodiment of the present application.

As shown in FIGS. 1 and 2, a string inverter is provided according to the present application, including an inverter main unit 1 and multiple wiring modules 2.

The inverter main unit 1 is a core module of a string inverter, and an inverter circuit is provided in the inverter main unit 1 to convert input direct current into alternating current with fixed frequency and fixed voltage or with variable frequency and variable voltage. The inverter main unit 1 is provided with a docking terminal 121a.

In some embodiments, the wiring modules 2 may all be direct current (DC) wiring modules, and each of the wiring modules 2 has an input end 21 and an output end 22. In this case, an AC unit member may further be configured in the inverter main unit 1. The input end 21 is configured to connect to an external DC input cable 3 for receiving direct current electricity generated by photovoltaic modules or the like, and the output end 22 is configured to connect to the docking terminal 121a to transmit the received direct current electricity to the inverter main unit 1. The AC unit member is connected to the inverter circuit to realize the convergence and output of alternating current electricity. The output current may be used for grid connection or for storage, which may be determined based on actual requirements.

In some optional embodiments, electronic devices related to DC input, such as a magnetic ring, a capacitor and the like, may also be provided in the wiring module 2. That is, all electronic devices related to DC input may be integrated in the wiring module 2. Consequently, there is no need to provide additional electronic devices related to DC input in the inverter main unit 1, which is conducive to modular design and facilitates subsequent maintenance and inspection of various modules.

It should be understood that the electronic devices related to DC input may also be partially arranged in the inverter main unit 1, as long as the function realization of the string inverter is not affected.

In an embodiment of the present application, the wiring module 2 is detachably mounted to the inverter main unit 1, so that the wiring module 2 has two states relative to the inverter main unit 1: a separated state and an assembled state.

In the separated state, the wiring module 2 may be connected to the DC input cable 3 first. In this case, since the wiring module 2 is not yet connected to the inverter main unit 1, the installation of the DC input cable 3 is not affected by the installation environment of the inverter main unit 1, and the connection between the DC input cable 3 and the wiring module 2 can be easily realized. Additionally, the weight of the individual wiring module 2 is relatively small, which facilitates an operator to adjust its installation posture and effectively reduces the labor intensity of the operator. Similarly, the weight of the individual inverter main unit 1 is also relatively small, facilitating the operator to install it on a wall, a bracket, or other components, thereby reducing labor intensity.

In the assembled state, the output end 22 of the wiring module 2 may be connected to the docking terminal 121a of the inverter main unit 1 to establish electrical connection between the wiring module 2 and the inverter main unit 1.

Herein, the embodiments of the present application do not limit the specific manner of detachable connection. In practical applications, those skilled in the art can choose the specific manner of detachable connection based on specific needs, as long as the relevant technical effects can be achieved. Exemplarily, the manner of detachable connection includes, but is not limited to screw (bolt) connection and snap-fit connection.

For the wiring modules 2, the types of the input ends 21 of the wiring modules 2 may be the same, or at least one of the wiring modules 2 may have an input end 21 whose type differs from the types of the input ends 21 of the other wiring modules 2. In other words, the type of the input end 21 of each wiring module 2 can be adjusted flexibly. With this configuration, in practical applications, the type of the string inverter can be adjusted by combining the wiring module 2 with the corresponding type of the input end 21, so as to adapt to different photovoltaic arrays, thereby improving the compatibility of the string inverter according to the present application and effectively reducing the usage cost of the string inverter.

Referring to FIG. 4, the input end 21 includes an input port 211, and the input end 21 can be specifically connected to the DC input cable 3 through the input port 211. The above-mentioned differences in the types of the input ends 21 may specifically include two situations: 1) the numbers of the input ports 211 of the input ends 21 are different, so as to adapt and connect to the DC input cables 3 with different numbers of paths; and 2) input currents of the input ports 211 of the input ends 21 are different, so as to adapt and connect to the DC input cables 3 with different input currents. The two situations may be either one or both.

Referring to FIG. 10, a DC circuit unit 24 may be provided inside the DC wiring module. The DC circuit unit 24 may include a DC switch 241, a DC lightning protection circuit 242, and a Maximum Power Point Tracking (MPPT) circuit 243, and the DC switch 241 may be connected to the input end 21. Depending on the type of the input end 21, the structure of the MPPT circuit 243 may vary, while the structural forms of the DC switch 241 and the DC lightning protection circuit 242 may remain unchanged.

In practical applications, the dimensions of the wiring modules 2 may be completely identical, facilitating the adjustment of the installation positions of the wiring modules 2 on the inverter main unit 1 and providing high flexibility during the installation process of the wiring modules 2. Alternatively, the dimensions of for the wiring modules 2 may also be inconsistent, which is an optional solution.

Herein, the embodiments of the present application do not limit the installation positions of the wiring modules 2 relative to the inverter main unit 1. In practical applications, those skilled in the art can design based on specific needs, as long as the reliable installation of the wiring modules 2 on the inverter main unit 1 can be ensured.

For ease of description, a coordinate system XYZ is established. Specifically, as shown in FIG. 1, a width direction of the string inverter may be defined as the X-axis direction, which may also be referred to as a front-to-back direction. A length direction of the string inverter may be defined as the Y-axis direction, which may also be referred to as a left-to-right direction. A height direction of the string inverter may be defined as the Z-axis direction, which may also be referred to as a top-to-bottom direction. In the Z-axis direction, the direction relatively away from the ground is defined as "top", and the direction relatively close to the ground is defined as "bottom".

The wiring module 2 may be located at a lower part of the inverter main unit 1, and the input end 21 may be located at a lower end of the wiring module 2, as illustrated in FIGS. 1 to 5 and FIG. 7. Alternatively, the wiring module 2 may be located at an upper part of the inverter main unit 1, and the input end 21 may be located at an upper end of the wiring module 2, as shown in FIG. 6. In the case, the input end 21 is in a position where it is relatively easy to connect to the DC input cable 3, facilitating the docking between the wiring module 2 and the DC input cable 3. Alternatively, the wiring module 2 may be located at a side part of the inverter main unit 1 in the Y-axis direction, as illustrated in FIGS. 7 and 8. In this case, the input end 21 is also in a position where it is relatively easy to connect to the DC input cable 3, facilitating the docking between the wiring module 2 and the DC input cable 3. Alternatively, the wiring module 2 may be located at a side part of the inverter main unit 1 in the X-axis direction, which also facilitates the docking between the wiring module 2 and the DC input cable 3.

The installation positions of the wiring modules 2 may not be the same. For example, for the wiring modules 2, some of the wiring modules 2 may be located at the upper part of the inverter main unit 1, or some of the wiring modules 2 may be located at the lower part of the inverter main unit 1, or some of the wiring modules 2 may be located at the side part of the inverter main unit 1.

For ease of explanation, the following description of the embodiments of the present application primarily focuses on the scenario where the wiring module 2 is located at the lower part of the inverter main unit 1.

As shown in FIGS. 2 and 3, the inverter main unit 1 may include a host unit 11 and a docking unit 12 arranged in the Z-axis direction. The aforementioned inverter circuit may be installed in the host unit 11, and the docking unit 12 is provided with the aforementioned docking terminal 121a for docking and assembly with the wiring module 2. The docking unit 12 may also be provided with a leg 14 for supporting the inverter main unit 1 and adjusting the installation height of the inverter main unit 1.

Specifically, the docking unit 12 may include two side plates 122 spaced apart from each other in the Y-axis direction and a back plate 121 connecting the two side plates 122. The docking terminal 121a may be disposed on the back plate 121, and the side plates 122 may be provided with openings 122a for heat dissipation. Between the two side plates 122, the docking unit 12 may also include multiple partitions 123 spaced apart in the Y-axis direction. The wiring module 2 may be inserted between two adjacent partitions 123 and between the partition 123 and the side plate 122. The partitions 123 may also be provided with notches (not shown in the figure) for heat dissipation.

Each of the lower end of the partition 123 and the lower end of the side plate 122 may be provided with a supporting plate 124, which can form a sliding rail for the wiring module 2. The wiring module 2 can slide along the supporting plate 124 to achieve a sliding connection between the wiring module 2 and the inverter main unit 1. In this way, each of the wiring modules 2 can adjust its relative position with respect to the inverter main unit 1 by sliding. It should be understood that the arrangement position of the sliding rail is not limited to the lower ends of the partition 123 and the side plate 122. The sliding rail may also be arranged at other positions, such as middle areas of the partition 123 and the side plate 122 in the Z-axis direction, as long as the use requirements for the sliding connection can be met.

In the above solution, the wiring module 2 slides along the X-axis direction. In addition, the wiring module 2 may slide in other directions, such as in the Z-axis direction, as illustrated in FIG. 6. That is, the implementation scope of the string inverter according to the present application is not limited by the sliding direction.

As shown in FIG. 9, in some other embodiments, the string inverter according to the present application may further include a hinge 13. The wiring module 2 may be mounted to the inverter main unit 1 via the hinge 13 to achieve a rotational connection between the wiring module 2 and the inverter main unit 1.

In this way, the relative position of the wiring module 2 with respect to the inverter main unit 1 can be adjusted through rotation. During installation, the docking between the DC input cable 3 and the wiring module 2 may be performed first, and then the wiring module 2 is installed to the inverter main unit 1. Alternatively, the wiring module 2 may be installed to the inverter main unit 1 first, and then the position of the wiring module 2 is adjusted through rotation of the wiring module 2, so that the input end 21 of the wiring module 2 can be exposed at a position where it is relatively easy to connect to the DC input cable 3, thus facilitating the connection between the wiring module 2 and the DC input cable 3.

For the solution involving the sliding connection or the rotational connection between the wiring module 2 and the inverter main unit 1, the string inverter according to the present application may further include a locking component. In a case that the output end 22 of the wiring module 2 is plugged into the docking terminal 121a of the inverter main unit 1, the locking component can lock the wiring module 2 and the inverter main unit 1 to lock the relative position of the wiring module 2 and the inverter main unit 1, thereby preventing the position of the wiring module 2 with respect to the inverter main unit 1 from changing during use.

The specific type of the locking component is not limited here. In practical applications, the specific type of the locking component may be determined by those skilled in the art based on specific needs. For example, the locking component may be a bolt, a lock pin, a lock plate, or other locking members in various forms.

In some optional embodiments, the wiring module 2 may further be provided with a limiting component 23 to limit the assembly position of the wiring module 2 on the inverter main unit 1. As shown in FIG. 4, the limiting component 23 may be formed at an end of the wiring module 2 away from the output end 22. When the output end 22 is plugged into the docking terminal 121a, the limiting component 23 can abut against the docking unit 12 along the X-axis direction to limit the insertion depth of the wiring module 2, thereby avoiding impact damage between the output end 22 and the docking terminal 121a.

### Second Embodiment

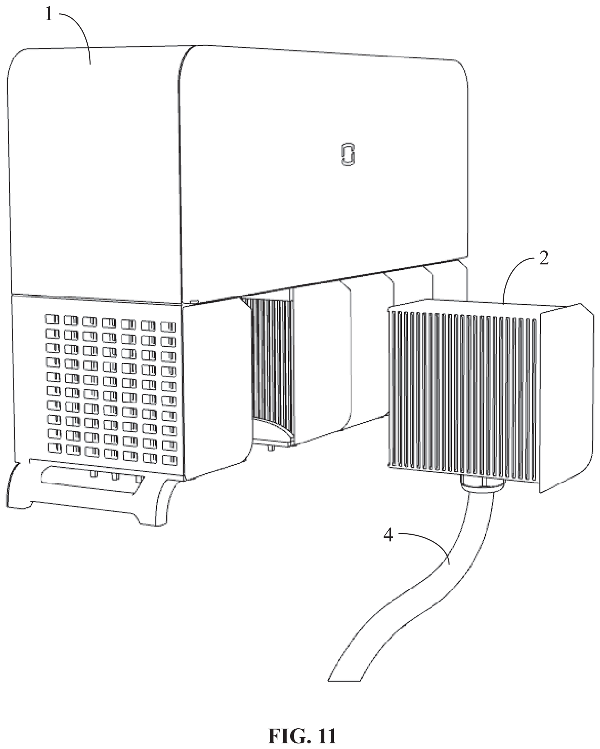

Referring to FIG. 11, FIG. 11 is a schematic structural view of a wiring module being an AC wiring module.

As shown in FIG. 11, the difference between this embodiment and the first embodiment lies in that: one of the wiring modules 2 may be an AC wiring module. The AC wiring module is connected to an AC output cable 4 for outputting alternating current to an external system.

With this solution, the AC unit member of the string inverter may also be modularly designed, facilitating installation and maintenance. Additionally, by adjusting the installation positions of the AC wiring module and other DC wiring modules, the extending position of the AC output cable 4 relative to the inverter main unit 1 can be adjusted, so as to facilitate connection with external devices.

The above is merely preferred embodiments of the present application. It should be pointed out that, those skilled in the art can also make various improvements and modifications without departing from the principles of the present application, and these improvements and modifications shall fall within the protection scope of the present application.

## Claims

1. A string inverter, **characterized by** comprising an inverter main unit (1) and a plurality of wiring modules (2), wherein each of the plurality of wiring modules (2) is detachably assembled to the inverter main unit (1) and has an input end (21).

2. The string inverter according to claim 1, wherein the wiring module (2) is a DC wiring module.

3. The string inverter according to claim 2, wherein the input end (21) comprises an input port (211); wherein
the number of the input ports (211) of at least one of the wiring modules (2) is different from that of at least one other of the wiring modules (2); and/or
an input current of the input port (211) of at least one of the wiring modules (2) is different from that of at least one other of the wiring modules (2).

4. The string inverter according to claim 2, wherein a DC circuit unit (24) is provided in the DC wiring module, and the DC circuit unit (24) comprises a DC switch (241), a DC lightning protection circuit (242), and a maximum power point tracking circuit (243).

5. The string inverter according to claim 1, wherein one of the wiring modules (2) is an AC wiring module.

6. The string inverter according to any one of claims 1 to 5, wherein the wiring module (2) is located at an upper part and/or a lower part and/or a side part of the inverter main unit (1).

7. The string inverter according to any one of claims 1 to 5, wherein the inverter main unit (1) is provided with a slide rail, and the wiring module (2) is slidably connected to the slide rail.

8. The string inverter according to claim 7, wherein the inverter main unit (1) is provided with a plurality of partitions (123), two adjacent wiring modules (21) are separated by the partition (123), a supporting plate (124) is provided at a lower end of each of the partitions (123), and the supporting plate (124) forms the slide rail.

9. The string inverter according to any one of claims 1 to 5, further comprising a hinge (13), wherein the wiring module (2) is rotatably connected to the inverter main unit (1) through the hinge (13).

10. The string inverter according to any one of claims 7 to 9, wherein the wiring module (2) is further provided with a limiting component (23) for limiting an assembly position of the wiring module (2) on the inverter main unit (1).
